(19) Europäisches Patentamt / European Patent Office / Office européen des brevets

(11) **EP 4 614 817 A2**

(12) **EUROPEAN PATENT APPLICATION**
published in accordance with Art. 153(4) EPC

(43) Date of publication:
**10.09.2025 Bulletin 2025/37**

(21) Application number: 23766185.5

(22) Date of filing: **04.07.2023**

(51) International Patent Classification (IPC):
*H03L 7/085* (2006.01)

(52) Cooperative Patent Classification (CPC):
**H04B 1/0458; G01S 7/28; G01S 7/282; G01S 7/35; G01S 13/02; G01S 13/34; G01S 13/58; H03L 7/085; H03L 7/089; H03L 7/093; H03L 7/099; H03L 7/18; H04B 1/04;** H04B 2001/045

(86) International application number:
**PCT/CN2023/105768**

(87) International publication number:
**WO 2023/169609 (14.09.2023 Gazette 2023/37)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **04.11.2022 CN 202211375634**

(71) Applicant: **Calterah Semiconductor Technology (Shanghai) Co., Ltd.**
**Shanghai 201210 (CN)**

(72) Inventor: **ZHOU, Wenting**
**Pudong New Area, Shanghai 201210 (CN)**

(74) Representative: **Balder IP Law, S.L.**
**Paseo de la Castellana 93**
**5ª planta**
**28046 Madrid (ES)**

(54) **PHASE-LOCKED LOOP, RADIO FREQUENCY SIGNAL TRANSMITTER, RADAR SENSOR AND ELECTRONIC DEVICE**

(57) The present disclosure provides a phase-locked loop, a radio frequency transmitter, a radar sensor and an electronic device. The phase-locked loop includes a phase-locked loop circuit, a charge compensation circuit that is controlled and a digital modulation controller. The phase-locked loop circuit is connected to the charge compensation circuit. The digital modulation controller is connected to the phase-locked loop circuit to output a frequency control signal so as to cause the phase-locked loop circuit to generate a valid interval of a frequency modulated signal in accordance with the frequency control signal. The digital modulation controller is further connected to the charge compensation circuit to control the charge compensation circuit to regulate charges in the phase-locked loop circuit within an invalid interval of the frequency modulated signal to shorten a duration of frequency callback of the frequency modulated signal.

FIG. 1

## Description

## CROSS REFERENCE TO RELATED APPLICATIONS

The present application claims priority to Chinese Patent Application No. 202211375634.6, filed November 4, 2022, which is incorporated by reference herein in its entirety.

## TECHNICAL FIELD

The present disclosure relates to the field of feedback control technology, and in particular to a phase-locked loop, a radio frequency transmitter, a radar sensor and an electronic device.

## BACKGROUND

A radar sensor detects an object in the surrounding environment by transmitting a detection signal wave, which utilizes a reflection mechanism of the object to an electromagnetic wave to sense an echo signal wave corresponding to the detection signal wave, and measures a physical quantity between the sensor and the object based on a frequency difference between the transmitting and reception.

In order to improve a detection resolution of the radar, one of the ways is to transmit more frequency modulated signals for the same length of time. For this reason, it is required to consider ways that can validly shorten a period of the frequency modulated signal. Meanwhile, process factors, such as reducing transformations to existing circuits that are in stable operation as much as possible, and considering a size limitation of a radar chip, etc., are also considered to achieve the way to validly shorten the period of the frequency modulated signal.

The above information disclosed in the present disclosure in the BACKGROUND section is intended only to enhance understanding of the background of the present disclosure, and as such it may include information that does not constitute prior art known to those of ordinary skill in the art.

## SUMMARY

A first aspect of the present disclosure provides a phase-locked loop including: a phase-locked loop circuit, a charge compensation circuit and a digital modulation controller. The phase-locked loop circuit is connected to the charge compensation circuit. The digital modulation controller is connected to the phase-locked loop circuit and configured to output a frequency control signal so as to cause the phase-locked loop circuit to generate a valid interval of a frequency modulated signal in accordance with the frequency control signal. The digital modulation controller is further connected to the charge compensation circuit and configured to control the charge compensation circuit to regulate charges in the phase-locked loop circuit during an invalid interval of the frequency modulated signal to shorten a duration of frequency callback of the frequency modulated signal.

A second aspect of the present application provides a radio frequency signal transmitter including: the phase-locked loop as described in the first aspect; and a radio frequency signal transmitting circuit connected to the phase-locked loop and configured to multiply a frequency of the frequency modulated signal provided by the phase-locked loop to output a frequency modulated radio frequency transmitting signal.

A third aspect of the present application provides a radar sensor including: a transmitting antenna for converting a radio frequency transmitting signal that is received into a detection signal wave; a receiving antenna for converting an echo signal wave into a radio frequency receiving signal, where the echo signal wave is formed by reflection of the detection signal wave by an object; the radio frequency transmitter as described in the second aspect, where the radio frequency transmitter is coupled to the transmitting antenna for outputting the radio frequency transmitting signal; and a signal receiver coupled to the receiving antenna to output a baseband digital signal using the radio frequency receiving signal and a local oscillator signal.

A fourth aspect of the present disclosure provides an electronic device including the radar sensor as described in the third aspect.

It should be understood that the above general description and the detailed descriptions in the following are merely exemplary and do not limit the present disclosure.

## BRIEF DESCRIPTION OF THE DRAWINGS

The above and other objectives, features, and advantages of the present disclosure become more apparent by describing exemplary embodiments with reference to the accompanying drawings in detail. The accompanying drawings described below are only some embodiments of the present disclosure and do not limit the present disclosure.

FIG. 1 shows a schematic structural diagram of a phase-locked loop circuit in an exemplary embodiment.

FIG. 2 shows a schematic structural diagram of a charge compensation circuit in an exemplary embodiment.

FIG. 3 shows a schematic diagram of a digital logic control circuit in an exemplary embodiment.

FIG. 4 shows a schematic diagram of a frequency modulated signal in an exemplary embodiment.

FIG. 5 shows a signal timing diagram of a digital control logic in an exemplary embodiment.

## DETAILED DESCRIPTION OF THE EMBODIMENTS

The present disclosure provides a phase-locked loop, a radio frequency transmitter, a radar sensor, and an electronic device, which shorten a period of a modulated waveform and realize a fast modulation function.

Exemplary embodiments are now described more comprehensively with reference to the accompanying drawings. However, the exemplary embodiments are capable of being implemented in a variety of forms and should not be construed as being limited to the embodiments set forth herein. In contrast, the provision of these embodiments allows the present disclosure to be comprehensive and complete and conveys the idea of the exemplary embodiments in a comprehensive manner to those skilled in the art. Identical reference numerals in the accompanying drawings indicate identical or similar portions, and thus repetitive descriptions of them are omitted.

The features, structures or characteristics described may be combined in one or more embodiments in any suitable manner. In the following description, many specific details are provided thereby giving a full understanding of the embodiments of the present disclosure. However, those skilled in the art should realize that it is possible to implement technical solutions in the present disclosure without one or more of these specific details, or that other means, components, materials, devices, etc. may be used. In these cases, commonly known structures, methods, devices, implementations, materials, or operations are not shown or described in detail.

The flowcharts shown in the accompanying drawings are only exemplary descriptions and are not necessary to include all elements and operations/steps, nor are they necessary to be performed in the order of presentation. For example, some of the operations/steps may also be divided, and some of the operations/steps may be combined or partially combined, and thus the order in which they are actually performed may change depending on the actual situation.

The terms 'first', 'second', and the like in the specification, claims and the accompanying drawings of the present disclosure are used to distinguish between different objects and are not used to describe a particular order. In addition, the terms 'comprising' and 'having', and any variations thereof, are intended to cover non-exclusive inclusion.

For example, a process, method, system, product, or apparatus including a series of steps or units is not limited to the listed steps or units, but optionally also includes steps or units that are not listed, or optionally includes other steps or units that are inherent to the process, method, product, or apparatus.

It should be understood by those skilled in the art that the accompanying drawings are merely schematic diagrams of exemplary embodiments, and that modules or processes in the accompanying drawings are not necessary to implement the present disclosure, and thus cannot be used to limit the protection scope of the present disclosure.

In some examples, fast modulation is needed to improve velocity resolution of a radar, and low transmit phase noise is needed to improve target detection. When using a frequency modulated continuous phase-locked loop for modulation, a bandwidth of the phase-locked loop is set smaller for lowering the phase noise, but the bandwidth of the phase-locked loop is set larger for fast modulation, such that the need for lowering the phase noise and the need for fast modulation are not compatible.

In order to meet the need of a detection distance of the radar sensor, the radar sensor systematically configures an intermediate frequency circuit and a radio frequency circuit to meet the bandwidth required for detection. Based on this, measurement accuracy of the radar sensor is related to the number of detection signal waves transmitted during a certain period of time, for example, the more detection signal waves transmitted, the higher the accuracy of a physical quantity of an object able to measured.

For the radar sensor, the transmitted detection signal waves are derived from a frequency modulated signal generated by an internal circuit including a frequency rise phase and a frequency fall phase. For the radar sensor, one of these phases (i.e. the frequency rise phase or the frequency fall phase) is usually adopted as a valid interval for the radar to carry out signal processing, and the other phase (i.e. the frequency fall phase or the frequency rise phase) is an invalid interval. Furthermore, an idle interval is usually included between adjacent frequency modulated signals so as to reserve a slot for locking of the phase-locked loop (PLL) that generates the frequency modulated signal.

To this end, the present disclosure provides a phase-locked loop intended to increase a transmit frequency of the frequency modulated signal by shortening a duration of the invalid interval, which is conducive to improving the accuracy of measurement of the physical quantity. The phase-locked loop includes a phase-locked loop circuit, a charge compensation circuit that is controlled, and a digital modulation controller. The digital modulation controller is connected to the phase-locked loop circuit to output a frequency control signal fn, so as to cause the phase-locked loop circuit to generate a frequency modulated signal fout. The digital modulation controller is further connected to the charge compensation circuit to control the charge compensation circuit to regulate charges in the phase-locked loop circuit within an invalid interval of the frequency modulated signal fout, so as to shorten a duration of frequency callback of the frequency modulated signal.

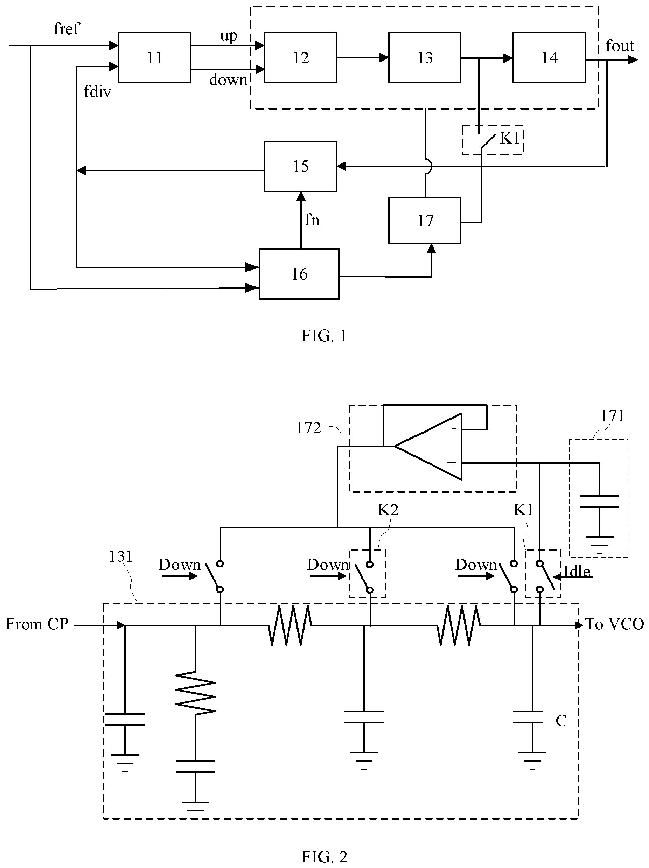

FIG. 1 shows a schematic structural diagram of a phase-locked loop circuit. The phase-locked loop circuit includes a phase frequency detector 11, a charge pump 12, a low-pass filter 13, a voltage-controlled oscillator 14, and a frequency divider 15. The phase frequency detector 11 receives a reference clock signal fref and a frequency divided signal fdiv, and detects hopping edges of the two signals to output a phase frequency detection signal (up, down). The charge pump 12 regulates an output current under control of the phase frequency detection signal. The low-pass filter 13 filters a received current, and the filtered electrical signal is output as a control signal to the voltage-controlled oscillator 14. The voltage-controlled oscillator 14 regulates a frequency of the output signal fout under the control of the control signal. The frequency divider divides the signal fout and outputs the frequency divided signal fdiv (fout/N) to realize a controlled and stable frequency of the signal fout by means of feedback.

As shown in FIG. 1, a digital modulation controller 16 is connected to the phase-locked loop circuit to output a frequency control signal, so as to cause the phase-locked loop circuit to generate a valid interval of the frequency modulated signal in accordance with the frequency control signal.

In some embodiments, fout=fref·N, and the digital modulation controller varies the divide ratio N in accordance with a preset frequency modulated rule, such that the frequency of the signal fout output from the voltage-controlled oscillator 14 varies regularly with time under action of the frequency divider 15, in order to form a kind of frequency modulated signal.

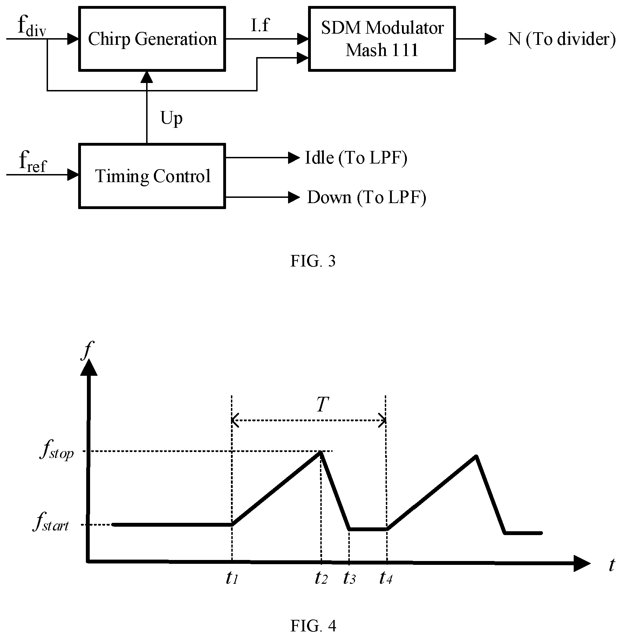

For example, the digital modulation controller 16 controls the frequency divider 15 such that the signal outputted by the voltage-controlled oscillator 14 is a frequency modulated signal whose frequency varies continuously and linearly, i.e., a frequency modulated continuous wave (FMCW) signal. FIG. 4 shows a schematic diagram of a frequency modulated signal, the horizontal axis represents time t, the vertical axis represents frequency f, fstart represents a start frequency of a frequency sweep waveform, and fstop represents a termination frequency of the frequency sweep waveform. The frequency of the frequency modulated signal rises from t1 to t2, and the time from t1 to t2 is an up time. The frequency of the frequency modulated signal quickly falls from t2 to t3, and the time from t2 to t3 is a down time. The frequency of the frequency modulated signal remains unchanged from t3 to t4, and the time from t3 to t4 is an idle time.

As shown in FIG. 4, the frequency modulated signal fout includes the valid interval, the invalid interval, and the idle interval. As described above, the valid interval utilized by the radar sensor corresponds to the up time or the down time in FIG. 4. The invalid interval is configured to enable the phase-locked loop circuit to call back the frequency of the frequency modulated signal, which may be the down time or the up time in FIG. 4, and the idle interval corresponds to the idle time in FIG. 4.

In order to shorten the invalid interval, the phase-locked loop further includes a charge compensation circuit 17, as shown in FIG. 1. The digital modulation controller is further connected to the charge compensation circuit, and controls the charge compensation circuit 17 to adjust charges in the phase-locked loop circuit during the invalid interval of the frequency modulated signal to shorten a duration for frequency callback of the frequency modulated signal. The charge compensation circuit 17 regulates the charges in the phase-locked loop circuit by injecting or draining the charges in the phase-locked loop circuit, such as regulating charges in the charge pump 12, regulating charges in the filter, or regulating charges to change a voltage/current of the control signal of the voltage-controlled oscillator, etc. The charge compensation circuit 17 regulates appropriate charges by collecting the charges in the filter and injecting them into the phase-locked loop circuit, which not only shortens the duration of frequency callback of the frequency modulated signal, but also allows the phase-locked loop circuit to quickly regain lock or reduces inappropriate oscillations of the phase-locked loop caused by loss of lock. Alternatively, the charge compensation circuit 17 regulates appropriate charges by collecting the charges in the filter and draining the charges through a circuit path in the phase-locked loop circuit, which not only shortens the duration of frequency callback of the frequency modulated signal, but also allows the phase-locked loop circuit to quickly regain lock or reduces inappropriate oscillations of the phase-locked loops caused by loss of lock.

As shown in FIG. 1, a first switch K1 is provided between the charge compensation circuit 17 and an output of the filter 13, and the first switch K1 is controlled by the digital modulation controller to switch on during the idle interval in which the frequency modulated signal fout is generated, so as to allow the charge compensation circuit 17 to collect and store charges from the filter 13 during the switching on of the first switch K1. The charge compensation circuit further includes an energy storage device, and at least one second switch (not shown) connected between the energy storage device and the phase-locked loop circuit. The at least one second switch is controlled by the digital modulation controller to switch on during the invalid interval of the frequency modulated signal fout to inject/drain appropriate charges utilizing the charge path in the phase-locked loop circuit. The charge compensation circuit further includes a buffer device provided on a current output path of the energy storage device to stabilize an output current.

FIG. 2 shows a schematic structural diagram of a charge compensation circuit. The first switch K1 is provided between the charge compensation circuit and the output of the filter 131, and the first switch K1 is controlled by a control signal Idle of the digital modulation controller to switch on during the idle interval in which the frequency modulated signal fout is generated. A capacitor 171 in the charge compensation circuit stores charges during the switching on of the first switch K1.

The charge compensation circuit further includes at least one second switch K2 connected between the capacitor 17 and the filter 131 in the phase-locked loop circuit. The filter 131 includes cascaded resistor capacitance (RC) filter units, and each of the at least one second switch K2 is connected to a respective one of the RC filter units. In a current control cycle of the frequency modulated signal, the first switch K1 switches on in the idle interval to cause the filter 131 to store charges in the capacitor 171. In a next control cycle of the frequency modulated signal, both the first switch K1 and the at least one second switch K2 switch off during the rising of the frequency modulated signal fout, and the charge compensation circuit as a whole does not participate in the phase-locked loop to generate the frequency modulated signal FMCW. During the invalid interval of the frequency modulated signal fout, the at least one second switch switches on under the control of a control signal Down of the digital modulation controller, and the charges in the capacitor 171 is assigned to the filter LPF, so that the frequency of the frequency modulated signal fout of the phase-locked loop quickly recovers from fstop to fstart, thereby accelerating a modulation cycle of the phase-locked loop. The charge compensation circuit further includes a buffer device provided on a current output path of the energy storage device.

According to exemplary embodiments, the present disclosure samples a control voltage of the voltage-controlled oscillator generated by the filter during the idle time of the frequency modulated signal FMCW, and imparts the control voltage to the filter at the beginning of the down time to accelerate stabilization time of the phase-locked loop, thereby reducing the period of the modulation waveform and realizing the rapid modulation function.

The digital modulation controller uses a received clock to perform operations such as logic processing, timing, or counting to output a frequency control signal and a plurality of control signals. The clock is, for example, a reference clock signal taken from an input of the phase-locked loop or a frequency divided signal of the frequency modulated signal. The reference clock signal may be generated by an oscillator such as a crystal. In relation to the timing of the output frequency control signal or other control signals, the digital modulation controller may generate a corresponding control signal based on the reference clock signal or the frequency divided signal. For example, the digital modulation controller may output a frequency controller based on either of the reference clock signal or the frequency divided signal to cause the phase-locked loop to generate the valid interval of the modulated signal. Although the frequency divided signal has a frequency or phase change due to the loss of lock of the phase-locked loop, the phase-locked loop circuit has achieved locking at the time of outputting the frequency control signal, i.e., the frequency divided signal and the reference clock signal are of the same frequency and in phase, and thus either of the reference clock signal or the frequency divided signal is reliable for controlling the phase-locked loop circuit to output the valid interval of the frequency modulated signal.

Some of additional control signals may be generated under the control of the reference clock signal. For example, the plurality of control signals include a control signal Up, a control signal Idle, and a control signal Down. The control signal Up is configured to indicate the valid interval of the frequency modulated signal. The control signal Idle is configured to indicate a signal for controlling the charge compensation circuit to store the charges during the idle interval in a cycle when the frequency modulated signal fout is periodically controlled. The control signal Down is configured to indicate a signal for controlling the charge compensation circuit to inject or drain charges during the idle interval of the frequency modulated signal. In some examples, different edges of a control signal may be configured to control the phase-locked loop to turn into different intervals during a cycle of transmitting the frequency modulated signal. For example, one type of edges (e.g., rising edges) of the control signal Idle are configured to control the at least one second switch in the charge compensation circuit to switch on, i.e., to enable the phase-locked loop to turn into the idle interval, and another type of edges (e.g., falling edges) of the control signal Idle is configured to control the at least one second switch in the charge compensation circuit to switch off, and to output the frequency control signal, i.e., to enable the phase-locked loop to turn into the valid interval. The digital modulation controller determines a duration of the valid interval by counting pulses of the frequency divided signal, outputs one type of edges (e.g., the rising edges) of the control signal Idle for controlling the first switch in the charge compensation circuit to switch on, i.e., to enable the phase-locked loop to turn into the invalid interval, until the end of the invalid interval is determined by counting the pulses of the reference clock signal, and outputs another type of edges (e.g., the falling edges) of the control signal Idle for controlling the first switch to switch off, i.e., to enable the phase-locked loop to turn from the invalid interval into the idle interval.

FIG. 3 shows a schematic diagram of a digital modulation controller. The digital modulation controller Digital Control includes a waveform generator (Chirp Generation), a Sigma Delta modulator (SDM Modulator) and a timing controller (Timing Control). The waveform generator (Chirp Generation) generates a divide ratio N sequence in real time according to a desired waveform requirement of the frequency modulated signal FMCW, where:

$$Nstart = fstart/fref$$

$$Nstop=fstop/fref,$$

fstart is a frequency of the frequency modulated signal FMCW at a start moment and fstop is a frequency of the frequency modulated signal FMCW at a stop moment in FIG. 4, and fref is a frequency of the reference clock signal.

In a high-precision frequency sweep waveform, the divide ratio N is usually not an integer, which is expressed as I.f (I indicates an integer part, f indicates a fractional part), and a sequence of decimal fractions is modulated into a sequence N of integers through the Sigma Delta Modulator (SDM Modulator), which is then sent to the frequency divider DividerN.

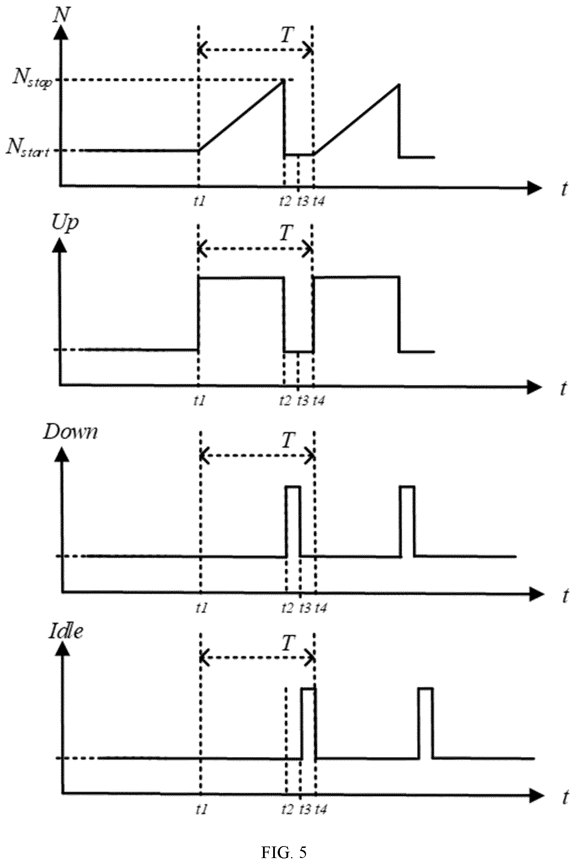

Taking the frequency rise period of the frequency modulated signal being the valid interval of the frequency modulated signal as an example, in order to produce a rapid modulation waveform, the divide ratio N is quickly transformed from Nstop back to Nstart at the beginning of the down time, as shown in FIG. 5. The phase-locked loop loses lock during the down time and remains locked during the idle time and the up time. In order to ensure that the entire modulation cycle will not be changed due to the loss of lock of the phase-locked loop, the timing controller (Timing Control) is added to the digital logic control circuit Digital Control, the control signal Idle corresponding to a start moment of the valid interval of the frequency modulated signal as well as the control signal Down corresponding to a start moment of the invalid interval of the frequency modulated signal is generated according to the reference clock signal fref to be output to the charge compensation circuit, and the control signal Up is generated according to the reference clock signal fref during the idle interval of the frequency modulated signal to be output to the waveform generator.

According to some embodiments, when the signal Up is valid (i.e., t1-t2 interval), the waveform generator starts counting progressively from Nstart to Nstop, and the Sigma Delta modulator outputs the frequency control signal fn to cause the phase-locked loop circuit to output the linear frequency modulated continuous FMCW. The signal Up is generated based on the clock fref, and the frequency control signal fn is generated based on the frequency divided signal fdiv. For a waveform generator using fdiv, fdiv and fref are asynchronous signals, but the change in the signal Up occurs at the beginning and end of the up time, and the frequency divided signal fdiv is synchronized in phase with the reference clock signal fref when the phase-locked loop is in lock. Therefore, the sampling of the signal Up by the frequency divided signal fdiv is able to be regarded as a synchronous circuit and does not bring about metastable effects of an asynchronous circuit.

During the period in which the control signal Up is invalid and the control signal Down is valid (i.e., t2-t3 interval), the frequency control signal fn has no output and each of the at least one second switch in the charge compensation circuit switches on in order to apportion the charges pre-stored in the charge compensation circuit to the filter, so that the filter further reduces a voltage value of the output control signal to increase a speed of decrease in the frequency of the signal output by the VCO.

During the period in which the control signal Down is invalid and the control signal Idle is valid (i.e., t3-t4 interval), each of the at least one second switch in the charge compensation circuit switches off and the first switch switches on to share the remaining charges in the filter to the capacitor in the charge compensation circuit.

A frequency of the signal output by the phase-locked loop circuit is adjusted within the invalid interval using the charges collected from the remaining charges in the filter, which validly accelerates the shortening of the duration for the phase-locked loop circuit to recover from the frequency Nstop to the start frequency Nstart, i.e., validly shortens the duration of the invalid interval. As a result, the radar sensor is able to transmit a greater number of detected electromagnetic waves within the same duration, so as to improve the accuracy of detecting the physical quantity of the object.

The present disclosure further provides a radio frequency signal transmitter including the phase-locked loop in the present disclosure, and a radio frequency signal transmitting circuit connected to the phase-locked loop for generating a desired baseband digital signal under a frequency modulated signal provided by the phase-locked loop.

The radio frequency signal transmitting circuit includes a frequency multiplier, and a driver amplifier. The frequency multiplier multiplies a frequency of the frequency modulated signal to a radio frequency band. The driver amplifier amplifies a power of the radio frequency transmitting signal output from the frequency multiplier to adapt a power for exciting antennas.

The radio frequency signal transmitting circuit further includes a phase shifter for phase control of radio frequency transmitting signals, whereby different sets of controlled radio frequency transmitting signals are able to detect objects in different beam directions and validly reduce signal interference between radars, etc.

The present disclosure further provides a radar sensor configured with an antenna array. The radar sensor utilizes a detection signal wave transmitted by the antenna array and an echo signal wave received to measure physical quantities between itself and obstacles in its surroundings, for example, to measure at least one of a relative velocity, a relative angle, a relative distance, and a three-dimensional contour of an obstacle, etc.

The radar sensor further includes the radio frequency transmitter and a signal receiver. The radio frequency signal transmitter converts a continuous frequency modulated signal generated by the phase-locked loop provided in any of the above examples into a radio frequency transmitting signal, and outputs the radio frequency transmitting signal to a transmitting antenna to cause the transmitting antenna to convert it into a detection signal wave to be radiated into free space. The frequency multiplier in the radio frequency transmitter further outputs the output radio frequency transmitting signal as a local oscillator signal to the signal receiver.

The radio frequency transmitter obtains the radio frequency transmitting signal swept at a center frequency and a preset bandwidth by frequency multiplying according to the frequency modulated signal generated by the phase-locked loop, and feeds to the transmitting antenna through the driver amplifier for transmitting a corresponding detection signal wave. When the detection signal wave is reflected by an object, the echo signal wave is formed. A receiving antenna converts the echo signal wave into a radio frequency receiving signal.

The signal receiver is configured to process the radio frequency receiving signal for down conversion, filtering, analog-to-digital conversion, etc., using the local oscillator signal, to output the baseband digital signal representing a difference frequency between the detection signal wave and the echo signal wave.

In some examples, the radar sensor further includes a signal processor.

The signal processor is connected to the signal receiver for extracting measurement information from the baseband digital signal by signal processing, performing the signal processing to obtain the measurement information of the radar sensor on an object, and outputting measurement data. The signal processing includes performing digital signal processing calculations such as phase, frequency, time domain, etc. on at least one to-be-processed signal provided by at least one receiving antenna. The measurement data includes at least one of distance data for indicating a relative distance of each of at least one detected obstacle, velocity data for indicating a relative velocity of each of the at least one detected obstacle, and angle data for indicating a relative angle of each of the at least one detected obstacle, etc.

The present disclosure further provides an electronic device including the radar sensor in the present disclosure.

In an alternative embodiment, the electronic device described above may be components and products for applications such as smart houses, transportation, smart homes, consumer electronics, surveillance, industrial automation, in-cabin detection, and health care. For example, the electronic device may be smart transportation devices (e.g., automobiles, bicycles, motorcycles, ships, subways, trains, etc.), security devices (e.g., cameras), liquid level/flow rate detection devices, smart wearable devices (e.g., bracelets, glasses, etc.), smart home devices (e.g., floor sweeping robots, door locks, televisions, air conditioners, smart lamps, etc.), various communication devices (e.g., mobile phones, tablets, etc.) and so on, as well as such as road gates, smart traffic lights, smart signs, and various industrialized robotic arms (or robots), etc., and also may be various instruments for detecting life characteristic parameters and various devices carrying such instruments, such as automotive in-cabin detection, indoor personnel monitoring, smart medical devices, consumer electronic devices, etc.

It should be clearly understood that the present disclosure describes how particular examples are formed and used, but the present disclosure is not limited to any details of those examples. Rather, based on the teachings of the present disclosure, these principles can be applied to many other embodiments.

Furthermore, it should be noted that the above accompanying drawings are only schematic descriptions of the processes included in the methods according to the exemplary embodiments of the present disclosure, and are not intended to limit. It is readily understood that the processes shown in the above accompanying drawings do not indicate or limit a chronological order of these processes. It is also readily understood that the processes may be performed, for example, synchronously or asynchronously in a plurality of modules.

Exemplary embodiments of the present disclosure are specifically shown and described above. It should be appreciated that the present disclosure is not limited to the detailed structure, arrangement, or method of implementation described herein. Rather, the present disclosure is intended to cover a variety of modifications and equivalent arrangements encompassed within the spirit and scope of the appended claims.

**Claims**

1. A phase-locked loop, comprising: a phase-locked loop circuit, a charge compensation circuit that is controlled and a digital modulation controller, wherein:

   the phase-locked loop circuit is connected to the charge compensation circuit;
   the digital modulation controller is connected to the phase-locked loop circuit and configured to output a frequency control signal so as to cause the phase-locked loop circuit to generate a valid interval of a frequency modulated signal in accordance with the frequency control signal; and the digital modulation controller is further connected to the charge compensation circuit and configured to control the charge compensation circuit to regulate charges in the phase-locked loop circuit during an invalid interval of the frequency modulated signal, to shorten a duration of frequency callback of the frequency modulated signal.

2. The phase-locked loop according to claim 1, wherein the phase-locked loop circuit includes a filter, and the charge compensation circuit is connected to the filter for regulating a voltage of a control signal output from the filter.

3. The phase-locked loop according to claim 2, wherein:

the charge compensation circuit is connected to an output of the filter; and
a first switch is provided between the charge compensation circuit and the output, wherein the first switch is controlled by the digital modulation controller to switch on within an idle interval between periodic generation of the frequency modulated signal so as to cause the charge compensation circuit to store charges during switching on of the first switch.

4. The phase-locked loop according to claim 2, wherein the charge compensation circuit includes an energy storage device, and at least one second switch connected between the energy storage device and the filter; and
wherein the at least one second switch is controlled by the digital modulation controller to switch on within an invalid interval of the frequency modulated signal to inject charges into the filter.

5. The phase-locked loop according to claim 4, wherein the charge compensation circuit further includes a buffer device provided on a current output path of the energy storage device.

6. The phase-locked loop according to claim 4, wherein the filter includes a resistor capacitance, RC, filter unit or a plurality of RC filter units in cascade, and wherein each of the at least one second switch is connected with each RC filter unit in one-to-one correspondence.

7. The phase-locked loop according to claim 1, wherein a duration of the valid interval is generated by timing using a reference clock signal or a frequency divided signal of the frequency modulated signal.

8. The phase-locked loop according to claim 7, wherein the reference clock signal is further output to an input of the phase-locked loop circuit for the phase-locked loop circuit to generate the frequency modulated signal using the reference clock signal and the frequency control signal.

9. A radio frequency transmitter comprising:

the phase-locked loop according to any one of claims 1 to 8;
a radio frequency signal transmitting circuit connected to the phase-locked loop and configured to multiply a frequency of the frequency modulated signal provided by the phase-locked loop to output a frequency modulated radio frequency transmitting signal.

10. A radar sensor comprising:

a transmitting antenna for converting a radio frequency transmitting signal that is received into a detection signal wave;
a receiving antenna for converting an echo signal wave into a radio frequency receiving signal, wherein the echo signal wave is formed by reflection of the detection signal wave by an object;
the radio frequency transmitter according to claim 9, wherein the radio frequency transmitter is coupled to the transmitting antenna for outputting the radio frequency transmitting signal; and
a signal receiver coupled to the receiving antenna to output a baseband digital signal using the radio frequency receiving signal and a local oscillator signal.

11. An electronic device comprising the radar sensor according to claim 10.

FIG. 1

FIG. 2

FIG. 3

FIG. 4

FIG. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202211375634